# EUROPEAN PATENT APPLICATION

(11) **EP 1 798 195 A2**
(43) Date of publication of application: **20.06.2007**
(21) Application number: 06252295.8
(22) Date of filing: 28.04.2006
(51) Int. Cl.: B81B 3/00

(54) **Comb-type electrode structure capable of large linear-displacement motion**

(30) Priority: 19.12.2005 KR 2005125454
(71) Applicant: Samsung Electronics Co., Ltd., Suwon-si, Gyeonggi-Do (KR)
(72) Inventor: Lee, Byeung-Leul, Yongin-si Gyeonggi-do (KR)
(74) Representative: Greene, Simon Kenneth

(57) **Abstract**

Provided is a vertical comb-type electrode structure capable of a large linear-displacement motion. The vertical comb-electrode structure includes: a first substrate including a plurality of vertical static comb-electrodes; and a second substrate stacked on an upper surface of the first substrate, the second substrate including a plurality of vertical moving comb-electrodes, wherein the static comb-electrodes vertically move a predetermined distance toward the moving comb-electrodes so that no gaps between the static comb-electrodes and the moving comb-electrodes exist.

## Description

### BACKGROUND OF THE INVENTION

The present invention relates to a vertical comb-type electrode structure provided by a micro-electromechanical system (MEMS) technique, and more particularly, to a vertical comb-type electrode structure which can perform a large linear-displacement motion.

Vertical comb-type electrode structures in which moving comb-electrodes (or a rotor) and static comb-electrodes (or a stator) are formed on a silicon-on-insulator (SOI) substrate are generally used in electrostatic sensors, micro light scanners, or microactuators.

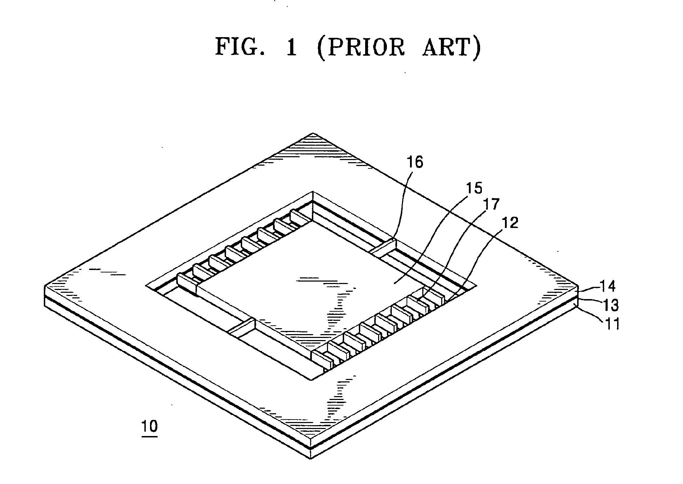

FIG. 1 is a perspective view of a conventional vertical comb-type electrode structure 10. Referring to FIG. 1, in the conventional vertical comb-type electrode structure 10, an upper silicon substrate 14 having moving comb-electrodes 17 is stacked on a lower silicon substrate 11 having static comb-electrodes 12. An insulation layer 13, for example, an oxide layer, is interposed between the lower silicon substrate 11 and the upper silicon substrate 14. The moving comb-electrodes 17 are vertically aligned on opposite sides of a driving plate 15 connected to the upper silicon substrate 14 through a spring 16. The static comb-electrodes 12 are formed on the lower silicon substrate 11 and alternate with the moving comb-electrodes 17. When voltages are applied to the moving comb-electrodes 17 and the static comb-electrodes 12, the driving plate 15 moves in a vertical direction or rotates due to an electrostatic force generated between the moving comb-electrodes 17 and the static comb-electrodes 12.

However, when a large displacement in a conventional vertical comb-type electrode structure happens, a non-linear motion occurs. When the conventional vertical comb-type electrode structure achieves a linear motion, the displacement therein becomes small.

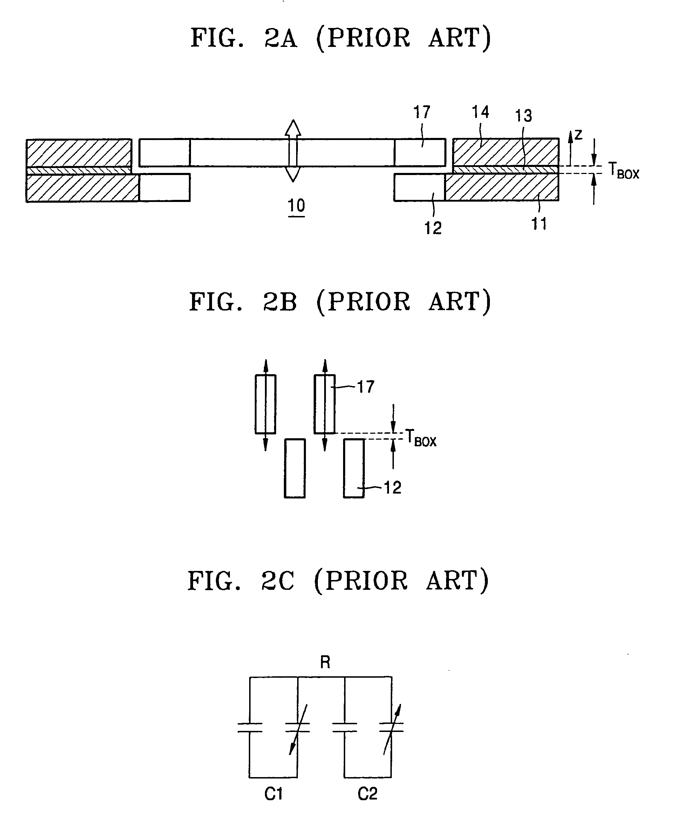

FIG. 2A is a cross-sectional view of a two-layered vertical comb-type electrode structure in which a relatively large displacement can be performed. Referring to FIG. 2A, since moving comb-electrodes 17 are formed in an upper silicon substrate 14 and static comb-electrodes 12 are formed in a lower silicon substrate 11, there is a gap T_{BOX} between the moving comb-electrodes 17 and the static comb-electrodes 12. The thickness of the gap T_{BOX} is the same as the thickness of an insulation layer 13, formed between the upper silicon substrate 14 and the lower silicon substrate 11. FIG. 2B illustrates relative positions of static comb-electrodes 12 and moving comb-electrodes 17. When the moving comb-electrodes 17 move up and down, the moving comb-electrodes 17 overlap the static comb-electrodes 12, so that the capacitance between the static comb-electrodes 12 and the moving comb-electrodes 17 changes. Accordingly, as illustrated in FIG. 2C, the vertical comb-type electrode structure is represented as an equivalent circuit where variable capacitors are connected in parallel. Referring to FIG. 2C, C1 denotes a capacitance between the right static comb-electrode 12 and the right moving comb-electrode 17, and C2 denotes a capacitance between the left static comb-electrode 12 and the left moving comb-electrode 17.

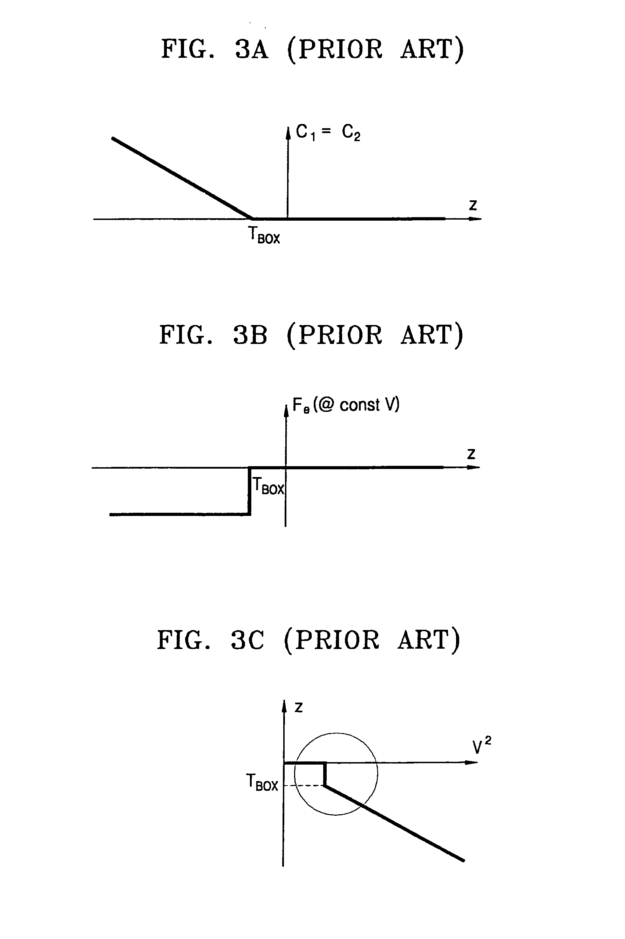

Since the capacitance increases as the overlapping area between the static comb-electrodes 12 and the moving comb-electrodes 17 increases, when the driving plate 15 moves in a vertical direction, the capacitance changes, as illustrated in FIG. 3A. That is, from the time when the static comb-electrodes 12 overlap the moving comb-electrodes 17, the capacitance linearly increases. In addition, when an applied voltage is constant, the electrostatic force Fₑ generated between the static comb-electrodes 12 and the moving comb-electrodes 17 is proportional to the capacitance change rate. Accordingly, the electrostatic force Fₑ is drastically changed from the time when the static comb-electrodes 12 overlap moving comb-electrodes 17 (z = -T_{BOX}), and then becomes constant, as illustrated in FIG. 3B. Since the electrostatic force Fₑ is proportional to the square of the applied voltage (V), the displacement of the driving plate 15 can be controlled by controlling the applied voltage. However, since the electrostatic force Fₑ shows a discontinuity at z = -T_{BOX}, the displacement of the driving plate 15 does not change when the applied voltage reaches a threshold value thereof, as illustrated in FIG. 3C. When the applied voltage is greater than the threshold value, the driving plate 15 drastically moves to a position of z = -T_{BOX}, and then linearly moves. Accordingly, the two-layered vertical comb-type electrode structure of FIG. 2A can provide a relatively large displacement, but cannot provide a linear motion at an applied voltage less than the threshold value.

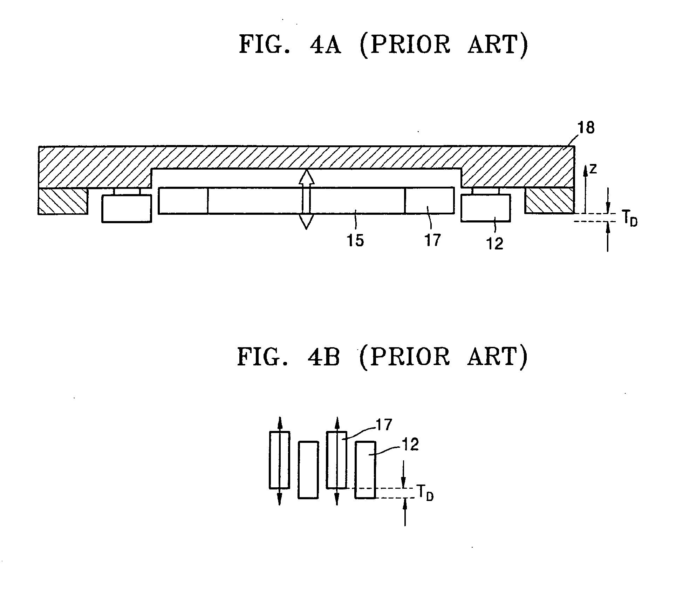

FIG. 4A is a cross-sectional view of another conventional vertical comb-type electrode structure for obtaining a linear motion. In the conventional vertical comb-type electrode structure illustrated in FIG. 4, static comb-electrodes 12 and moving comb-electrodes 17 are formed on the same plane and overlap each other. Then the static comb-electrodes 12 are displaced downwards by an upper cover 18 by a distance T_{D}. FIG. 4B illustrates a relative position of the moving comb-electrodes 17 and the static comb-electrodes 12.

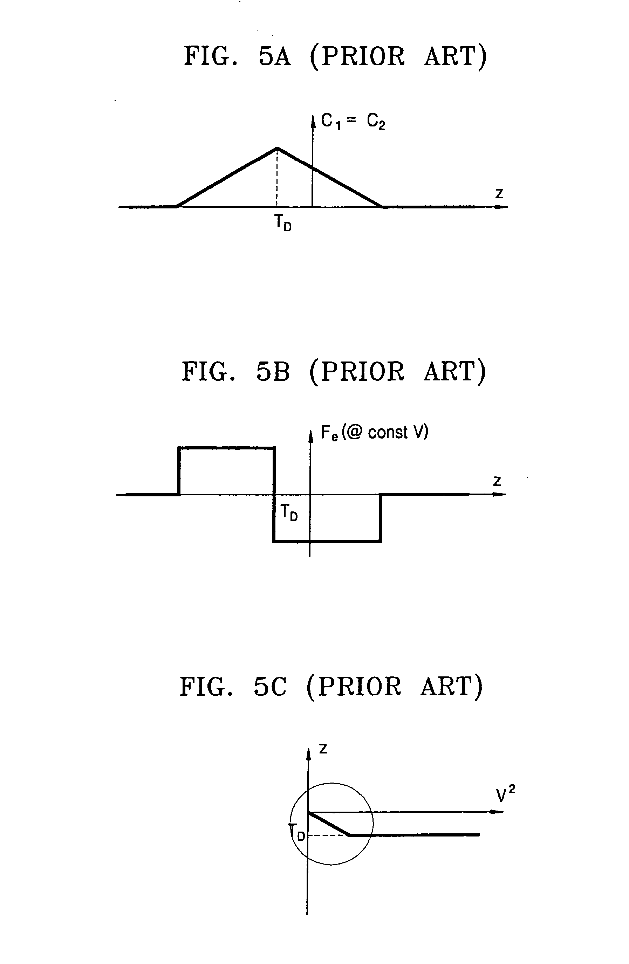

In such a structure, FIG. 5A shows the change of capacitance corresponding to the movement of a driving plate 15. When the moving comb-electrodes 17 are moved the distance T_{D} to entirely overlap the static comb-electrodes 12, the capacitance is maximized. Unlike the vertical comb-type electrode structure of FIG. 2A, since there is no initial gap between the static comb-electrodes 12 and the moving comb-electrodes 17, non-linear motion does not occur in the vertical comb-type electrode structure of FIG. 4A. However, as illustrated in FIG. 5B, when the driving plate 15 moves a distance greater than T_{D}, the direction of the electrostatic force Fₑ becomes opposite, so that the driving plate 15 cannot move a distance greater than T_{D}, as illustrated in FIG. 5C. Accordingly, the vertical comb-type electrode structure of FIG. 4A cannot provide a large displacement.

### SUMMARY OF THE INVENTION

The present invention provides a simple vertical comb-type electrode structure that provides a large linear displacement motion.

The present invention also provides an electrostatic sensor, a microactuator, or a micro light scanner using the vertical comb-type electrode structure.

According to an aspect of the present invention, there is provided a vertical comb-electrode structure including: a first substrate including a plurality of vertical static comb-electrodes; and a second substrate stacked on an upper surface of the first substrate, the second substrate including a plurality of vertical moving comb-electrodes, wherein the static comb-electrodes are vertically moved a predetermined distance toward the moving comb-electrodes so that no gaps between the static comb-electrodes and the moving comb-electrodes exist.

The vertical comb-electrode structure may further include: a base substrate disposed under the first substrate, wherein protruding portions vertically pressing the static comb-electrodes toward the moving comb-electrodes are formed on the base substrate so that the static comb-electrodes at least partially overlap the moving comb-electrodes

An insulation layer may be interposed between the first substrate and the second substrate.

A thickness of the protruding portions formed on the surface of the base substrate may be greater than at least a thickness of the insulation layer.

The first substrate and the static comb-electrodes may be integrally formed in the same plane, and a spring may be integrally formed between the first substrate and the static comb-electrodes so that the static comb-electrodes are vertically displaced with respect to the first substrate.

The second substrate may further include a driving plate integrally formed therewith in the same plane, and a spring may be integrally formed between the second substrate and the driving plate so that the driving plate is moved in a vertical direction or rotated with respect to the second substrate.

The plurality of moving comb-electrodes may be vertically aligned and parallel to each other on sides of the driving plate.

According to another aspect of the present invention, there is provided a micro light scanner includes the vertical comb-type electrodes structure.

According to another aspect of the present invention, there is provided a micro actuator includes the vertical comb-type electrodes structure.

According to another aspect of the present invention, there is provided an electrostatic sensor includes the vertical comb-type electrodes structure.

### BRIEF DESCRIPTION OF THE DRAWINGS

The above and other features and advantages of the present invention will become more apparent by describing in detail exemplary embodiments thereof with reference to the attached drawings in which:
FIG. 1 is a perspective view of a conventional vertical comb-type electrode structure;
FIG. 2A is a cross-sectional view of a conventional vertical comb-type electrode structure;
FIG. 2B illustrates relative positions of static comb-electrodes and moving comb-electrodes in the conventional vertical comb-type electrode structure of FIG. 2A;
FIG. 2C is an equivalent circuit for the conventional vertical comb-type electrode structure of FIG. 2A;
FIGS. 3A through 3C illustrate characteristics of the conventional vertical comb-type electrode structure of FIG. 2A;
FIG. 4A is a cross-sectional view of another conventional vertical comb-type electrodes structure;
FIG. 4B illustrates relative positions of static comb-electrodes and moving comb-electrodes in the conventional vertical comb-type electrode structure of FIG. 4A;
FIG. 5A through 5C illustrate characteristics of the conventional vertical comb-type electrode structure of FIG. 4A;
FIG. 6A is a cross-sectional view of a vertical comb-type electrode structure that vertically moves, according to an embodiment of the present invention;
FIG. 6B illustrates relative positions of static comb-electrodes and moving comb-electrodes in the vertical comb-type electrode structure of FIG. 6A;
FIGS. 7A through 7C illustrate characteristics of the vertical comb-type electrode structure of FIG. 6A;
FIG. 8 is a cross-sectional view of a vertical comb-type electrode structure that rotates, according to an embodiment of the present invention;
FIGS. 9A through 9C illustrate characteristics of the vertical comb-type electrode structure of FIG. 8; and
FIG. 10 is an exploded perspective view of a vertical comb-type electrode structure according to an embodiment of the present invention.

### DETAILED DESCRIPTION OF THE INVENTION

Hereinafter, the present invention will be described more fully with reference to the accompanying drawings, in which exemplary embodiments of the invention are shown.

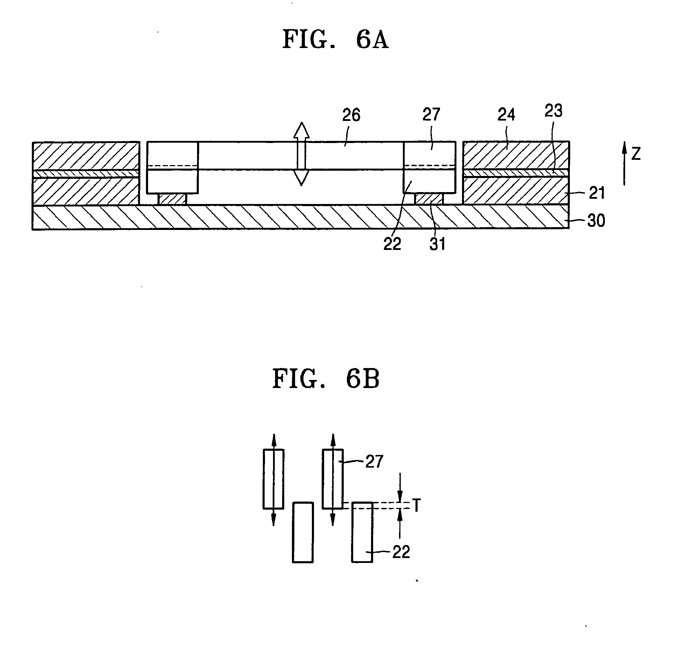

FIG. 6A is a cross-sectional view of a vertical comb-type electrode structure that vertically moves, according to an embodiment of the present invention. Referring to FIG. 6A, a silicon-on-insulator (SOI) substrate including a lower silicon substrate 21 and an upper silicon substrate 24 is bonded to a base substrate 30. The bonding method is, for example, an anodic bonding method, a silicon direct bonding (SDB) method, or a metallic bonding method. Like the conventional art, an insulation layer 23, for example, an oxide layer, is interposed between the lower silicon substrate 21 and the upper silicon substrate 24 so that electric shorts between the lower silicon substrate 21 and the upper silicon substrate 24 are prevented. A plurality of vertical static comb-electrodes 22 are integrally formed with the lower silicon substrate 21 in the same plane. In addition , a driving plate 26 and a plurality of vertical moving comb-electrodes 27 are integrally formed in with the upper silicon substrate 24 in the same plane. As illustrated in FIG. 6A, the plurality of moving comb-electrodes 27 are vertically aligned and parallel to each other on opposite sides of the driving plate 26.

Protruding portions 31 are formed on the surface of the base substrate 30 to correspond to the static comb-electrodes 22, and press the static comb-electrodes 22 toward the moving comb-electrodes 27. According to an embodiment of the present invention, the thickness of the protruding portions 31 formed on the surface of the base substrate 30 may be greater than at least the thickness of the insulation layer 23. Accordingly, as illustrated in FIG. 6A, the static comb-electrodes 22 are vertically moved toward the moving comb-electrodes 27 to partially overlap the moving comb-electrodes 27.

FIG. 6B is a cross-sectional view of the static comb-electrodes 22 and the moving comb-electrodes 27 of FIG. 6A. FIG. 6B illustrates relative positions of the plurality of static comb-electrodes 22, which are vertically moved by the protruding portions 31, and the plurality of the moving comb-electrodes 27. Referring to FIG. 6B, in the vertical comb-type electrode structure according to the current embodiment of the present invention, the static comb-electrodes 22 vertically overlap the moving comb-electrodes 27 by a predetermined distance T (T≥ 0).

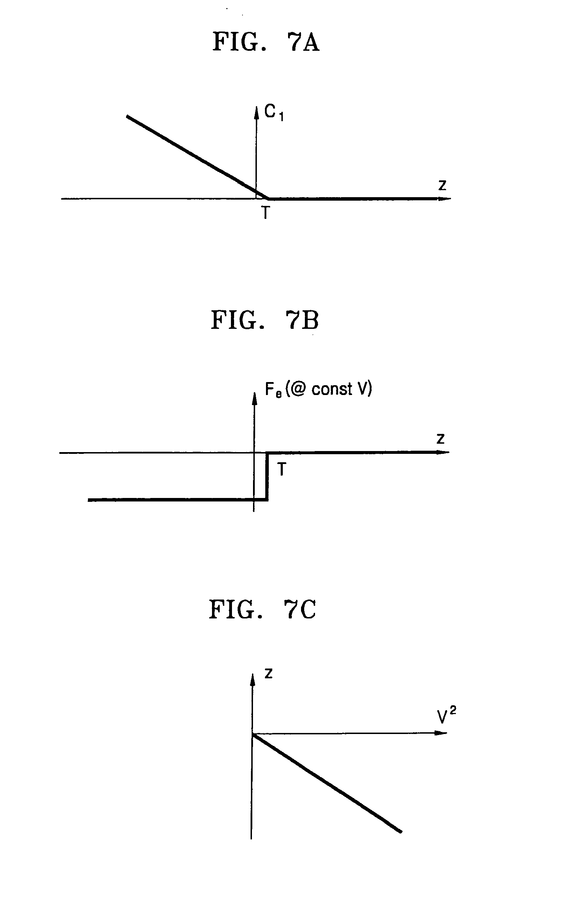

Accordingly, when the moving comb-electrodes 27 are vertically moved, that is, in the arrow direction of FIG. 6B, capacitance generated between the static comb-electrodes 22 and the moving comb-electrodes 27 changes, as illustrated in FIG. 7A. That is, when the direction of the vertical motion of the moving comb-electrodes 27 is set as a z-axis, and the position of a bottom end portion of the moving comb-electrodes 27 before moving is defined as the origin of the z-axis, the capacitance linearly increases as the moving comb-electrodes 27 move from z = +T along the -z direction. In addition, if an applied voltage is constant, electrostatic force (Fₑ) generated by the capacitance change is constant when the moving comb-electrodes 27 move from z = +T along the -z direction, as illustrated in FIG. 7B. Accordingly, in the vertical comb-type electrode structure according to the current embodiment of the present invention, the moving comb-electrodes 27 overlap the static comb-electrodes 22 by a distance T at an initial position (z=0), and thus the moving comb-electrodes 27 can linearly move. That is, as illustrated in FIG. 7C, the vertical movement of the moving comb-electrodes 27 is proportional to a square of the applied voltage. To increase the displacement range of the moving comb-electrodes 27, the distance T is small. In particular, when a top end portion of the static comb-electrodes 22 matches the bottom end portion of the moving comb-electrodes 27, that is, T = 0, the moving comb-electrodes 27 can linearly move.

Thus, in the vertical comb-type electrode structure according to the current embodiment of the present invention, linear motion is possible, compared with the conventional art in FIG. 2A. In addition, larger displacement can be obtained, compared with the conventional art in FIG. 4A.

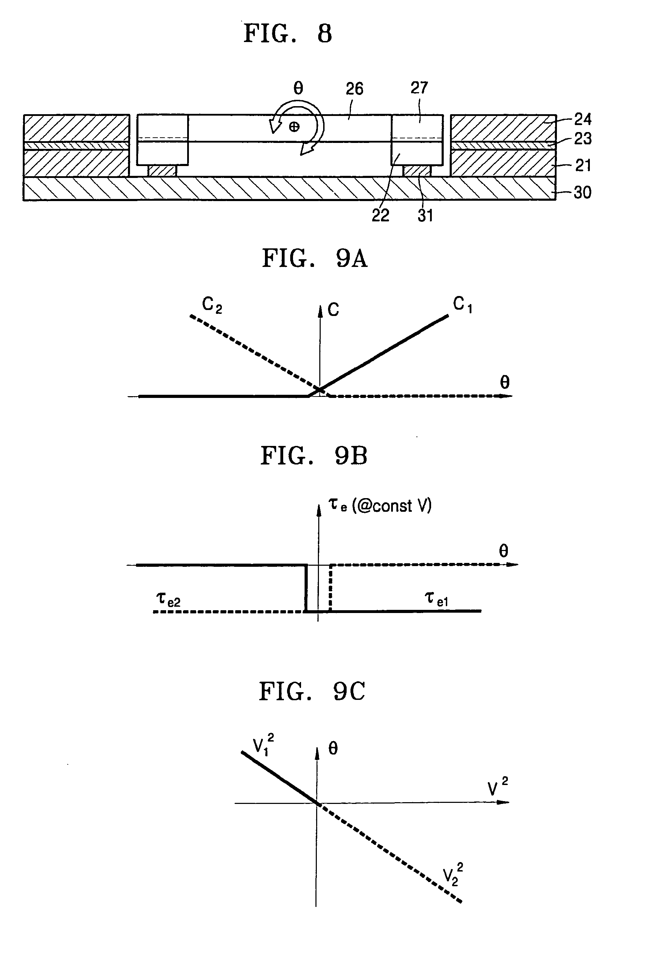

FIG. 8 is a cross-sectional view of a vertical comb-type electrode structure that rotates. The driving plate 26 in the vertical comb-type electrode structure of FIG. 6A moves in a vertical direction, as indicated by an arrow. However, the driving plate 26 in the vertical comb-type electrode structure of FIG. 8 rotates, as indicated by an arrow. Vertical motion and rotational motion can be selected according to how a voltage is applied to the vertical comb-type electrode structures of FIGS. 6A and FIG. 8, respectively. For obtaining the motion in a vertical direction, in the vertical comb-type electrode structure of FIG. 6A, the same voltages are applied to both sides of the static comb-electrodes 22 and the moving comb-electrodes 27. Meanwhile, for obtaining the rotational motion, as illustrated in FIG. 8, opposite directional voltages are applied to both sides of the static comb-electrodes 22, or a voltage is alternately applied to both sides of the static comb-electrodes 22.

When the driving plate 26 rotates as illustrated in FIG. 8, capacitance between the static comb-electrodes 22 and the moving comb-electrodes 27 changes, as illustrated in FIG. 9A. In FIG. 9A, C1 denotes a capacitance between a right static comb-electrode 22 and a right moving comb-electrode 27, and C2 denotes capacitance between a left static comb-electrode 22 and a left moving comb-electrodes 27. When the driving plate 26 is horizontally disposed, the angle (θ) is 0°. When the driving plate 26 rotates in a clockwise direction, θ > 0°. When the driving plate 26 rotates in a counter-clockwise direction, θ < 0°. The capacitance C1 between the right static comb-electrode 12 and the right moving comb-electrode 17 linearly increases, when the driving plate 26 rotates in a clockwise direction, that is, when θ increases. Meanwhile, the capacitance C2 between the left static comb-electrode 12 and the left moving comb-electrode 17 linearly increases, when the driving plate 26 rotates in a counter-clockwise direction, that is, when θ decreases. The static comb-electrodes 22 overlap the moving comb-electrodes 27 at an origin position. Thus, as illustrated in FIG. 9A, C1 increases from an angle less than 0°, and C2 increases from an angle greater than 0°.

Accordingly, electrostatic torqueT ₑ caused by the capacitance change changes, as illustrated in FIG. 9B. For example, a first torqueT ₑ₁ acting in a clockwise direction is constant when θ > 0, and a second torqueT ₑ₂ acting in a counter-clockwise direction is constant when θ < 0. As illustrated in FIG. 9C the driving angle θ in the clockwise or counter-clockwise direction is linearly proportional to the square of applied voltage.

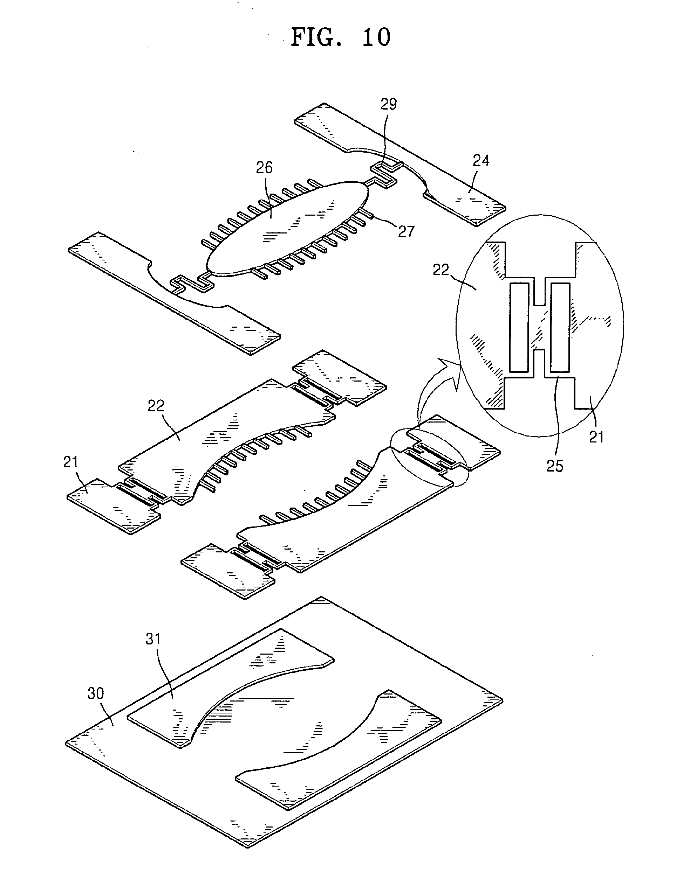

FIG. 10 is an exploded perspective view of a vertical comb-type electrode structure according to an embodiment of the present invention. Referring to FIG. 10, a lower silicon substrate 21 having static comb-electrodes 22 is stacked on a base substrate 30, and an upper silicon substrate 24 having moving comb-electrodes 27 is stacked on the lower silicon substrate 21. Although not illustrated, an oxide layer is interposed between the lower silicon substrate 21 and the upper silicon substrate 24 for insulation therebetween.

As described above, the lower silicon substrate 21 and the static comb-electrodes 22 are formed in the same plane. For example, a single silicon substrate is etched so that the lower silicon substrate 21 is integrally formed with the static comb-electrodes 22. As illustrated in FIGS. 6A and 8, since the protruding portions 31 are formed on an upper surface of the base substrate 30 corresponding to the static comb-electrodes 22, the static comb-electrodes 22 are upwardly moved by a thickness of the protruding portion 31 when the lower silicon substrate 21 is stacked. To move the static comb-electrodes 22 with respect to the lower silicon substrate 21, the lower silicon substrate 21 may be connected to the static comb-electrodes 22 through a plate spring 25, as shown in an enlarged portion of FIG. 10. The plate spring 25 may be integrally formed with the lower silicon substrate 21 and the static comb-electrodes 22 using an etching process.

The upper silicon substrate 24 includes a driving plate 26 which moves in a vertical direction or rotates , and a plurality of moving comb-electrodes 27 are vertically aligned and parallel to each other on opposite sides of the driving plate 26. The driving plate 26 is connected to the upper silicon substrate 24 through a torsion spring 29 for a vertical motion or a rotational motion with respect to the upper silicon substrate 24, as illustrated in FIG. 10. Like the lower silicon substrate 21, the upper silicon substrate 24, the driving plate 26, the moving comb-electrodes 27, and the torsion spring 29 are integrally formed in the same plane by etching a single silicon substrate.

As described above, in the vertical comb-type electrode structure according to the current embodiment of the present invention, large displacement motion and linear motion are both possible. Accordingly, the vertical comb-type electrode structure can be properly applied to a micro light scanner, a microactuator, or an electrostatic sensor. For example, when the vertical comb-type electrode structure is used in a micro light scanner which scans images at high speed in a laser TV, a mirror is formed on the surface of the driving plate 26, and voltages are applied to the static comb-electrodes 22 and the moving comb-electrodes 27 so that the driving plate 26 having the mirror rotates at high speed. In addition, when the vertical comb-type electrode structure is used as a microactuator, voltages are applied to the static comb-electrodes 22 and the moving comb-electrodes 27 so that the driving plate 26 moves in a vertical direction. Alternatively, instead of driving the driving plate 26 by applying voltages to the static comb-electrodes 22 and the moving comb-electrodes 27, a capacitance change between the static comb-electrodes 22 and the moving comb-electrodes 27 caused by the vibration of the driving plate 26 can be measured to sense inertia, etc. That is, the vertical comb-type electrode structure can be used as an electrostatic sensor.

In present invention, static comb-electrodes overlap moving comb-electrodes due to protruding portions of a base substrate so that a vertical comb-type electrode structure in which large displacement motion and linear motion are possible, is provided in a simple manner and at low cost.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A vertical comb-electrode structure comprising:
a first substrate comprising a plurality of vertical static comb-electrodes; and
a second substrate stacked on an upper surface of the first substrate, the second substrate comprising a plurality of vertical moving comb-electrodes,
wherein the static comb-electrodes vertically move a predetermined distance toward the moving comb-electrodes so that no gaps between the static comb-electrodes and the moving comb-electrodes exist.

2. The vertical comb-electrode structure of claim 1, further comprising:
a base substrate disposed under the first substrate,
wherein protruding portions vertically pressing the static comb-electrodes toward the moving comb-electrodes are formed on the base substrate so that the static comb-electrodes at least partially overlap the moving comb-electrodes

3. The vertical comb-electrode structure of claim 2, wherein an insulation layer is interposed between the first substrate and the second substrate.

4. The vertical comb-electrode structure of claim 3, wherein a thickness of the protruding portions formed on the surface of the base substrate is greater than at least a thickness of the insulation layer.

5. The vertical comb-electrode structure of any preceding claim,
wherein the first substrate and the static comb-electrode are integrally formed in the same plane, and a spring is integrally formed between the first substrate and the static comb-electrodes so that the static comb-electrodes can be vertically displaced with respect to the first substrate.

6. The vertical comb-electrode structure of claim 5, wherein the second substrate further comprises a driving plate integrally formed therewith in the same plane, and a spring is integrally formed between the second substrate and the driving plate so that the driving plate can be moved in a vertical direction or rotated with respect to the second substrate.

7. The vertical comb-electrodes structure of claim 6, wherein the plurality of moving comb-electrodes are vertically aligned and parallel to each other on sides of the driving plate.

8. A micro optical scanner comprising:
a first substrate comprising a plurality of vertically aligned static comb-electrodes; and
a second substrate stacked on an upper surface of the first substrate, the second substrate comprising a driving mirror integrally formed therewith in the same plane and a plurality of vertical moving comb-electrodes formed on sides of the mirror,
wherein the static comb-electrodes are vertically moved a predetermined distance toward the moving comb-electrodes so that no gaps between the static comb-electrodes and the moving comb-electrodes exist.

9. The micro optical scanner of claim 8, further comprising:
a base substrate disposed under the first substrate,
wherein protruding portions vertically pressing the static comb-electrodes toward the moving comb-electrodes are formed on the base substrate so that the static comb-electrodes at least partially overlap the moving comb-electrodes

10. The micro optical scanner of claim 9, wherein an insulation layer is interposed between the first substrate and the second substrate.

11. The micro optical scanner of claim 10, wherein a thickness of the protruding portions formed on the surface of the base substrate is greater than at least a thickness of the insulation layer.

12. The micro optical scanner of claim 8, 9, 10 or 11, wherein the first substrate is integrally formed with the static comb-electrodes in the same plane, and a spring is integrally formed between the first substrate and the static comb-electrodes so that the static comb-electrodes can be vertically displaced with respect to the first substrate.

13. The micro optical scanner of any of claims 8 to 13, wherein a spring is integrally formed between the second substrate and the driving mirror so that the driving mirror can move in a vertical direction or rotate with respect to the second substrate.
